Europäisches Patentamt

European Patent Office

Office européen des brevets

(19)

(11) Publication number: **0 207 554**
**B1**

# EUROPEAN PATENT SPECIFICATION

(12)

(45) Date of publication of the patent specification:
**09.05.90**

(51) Int. Cl.⁵: **G01R 29/24**, G03G 15/02

(21) Application number: **86201066.7**

(22) Date of filing: **19.06.86**

(54) Method of and device for determining a measure of the surface potential of a medium charged by means of a corona charging device.

(30) Priority: **01.07.85 NL 8501886**

(43) Date of publication of application:
**07.01.87 Bulletin 87/2**

(45) Publication of the grant of the patent:
**09.05.90 Bulletin 90/19**

(84) Designated Contracting States:
**DE FR GB NL**

(56) References cited:
**EP-A- 0 001 886**
**US-A- 3 604 925**
**US-A- 3 699 388**

(73) Proprietor: **Océ-Nederland B.V., St. Urbanusweg 43, NL-5914 CC Venlo(NL)**

(72) Inventor: **Cox, Jan Jacobus Franciscus Marie, Beringerhoek 9, NL-5986 AR Helden-Beringe(NL)**
Inventor: **Ensing, Hendrik, Schoolstraat 28, NL-5941 GC Velden(NL)**

(74) Representative: **Hanneman, Henri W.A.M., Océ-Nederland B.V. Patents and Information Postbus 101, NL-5900 MA Venlo(NL)**

## Description

The invention relates to a method of determining a measure E of the surface potential of a medium charged by means of a corona charging device, in which charge emitted by the corona electrode or electrodes is deposited on the medium surface and a measuring wire is disposed near the charged surface to collect a part of the emitted charge, and in which the measure E is derived from the value $i_d$ of the charge current collected by the measuring wire. The invention also relates to a device for performing the said method, which device is provided with a measuring wire disposed near the surface to be charged, and a first measuring circuit for determining the value $i_d$ of the current collected by the measuring wire, the measuring circuit delivering a first signal which represent the value of the determined current.

A method and device of this kind are known from US patent 3 604 925.

It has been found that the known method and device for determining a measure of the surface potential are relatively inaccurate.

The object of the invention is to provide a method and device with which the measure E can be accurately determined. According to the invention this object is achieved in that further to the method of the kind referred to in the preamble, a measure $i_f$ of the portion of the emitted charge current that is conveyed to the medium is determined, and in that the measure E is corrected by a correction C which correction is an invariant first order function of $i_f$.

The invention is also based on the realization that the inaccuracy of measurement is caused primarily by variations in the charge current $i_f$ as the result of variations, for example, in the charging characteristics of the medium to be charged and also on the realization that the influence of $i_f$ on the measurement can be predicted. The accuracy of the measurement is greatly improved by determining the charge current $i_f$ and then correcting the measure E by a value dependent upon the value $i_f$.

An attractive variant of the method according to the invention is characterised in that the value $i_{tot}$ of the charge current emitted by the corona electrode or electrodes is determined and in that the measure $i_f$ is derived from the value $i_{tot}$ in accordance with a fixed relation. The advantage of this variant is that a measure $i_f$ of that part of the emitted charge current which is conveyed to the medium and which is difficult to measure can be readily determined from the easily measured charge current emitted by the corona electrode or electrodes. This simplification is rendered possible by the fact that the measure $i_f$ has been found to be satisfactorily predictable by reference to the value $i_{tot}$.

A variant of the method according to the invention, in which the position of the measuring wire is so selected that the measuring wire collects only charge moving towards the medium surface, is very attractive because of its high sensitivity.

In a device of the kind referred to in the preamble for performing the above method, the object aimed at is achieved according to the invention in that the device comprises a second measuring circuit for determining the value $i_f$, which delivers a second signal which represents the determined value $i_f$, and a computer circuit to which the first signal and the second signal are fed, and which from the supplied signals generates in accordance with a fixed equation an output signal which represents the measure E.

The invention will be explained in detail with reference to two embodiments and Figs. 1 to 5 in which:

Fig. 1 is a diagram of the corona charging device;
Fig. 2 is a graph showing the relationship between the wire current and the photoconductor current at different surface potentials of the photoconductor;
Fig. 3 is a diagram of an embodiment of a first control system in which the invention is used;
Fig. 4 is a diagram of an embodiment of a second control system in which the invention is used;
Fig. 5 is a time diagram to explain the operation of the control system of Fig. 4.

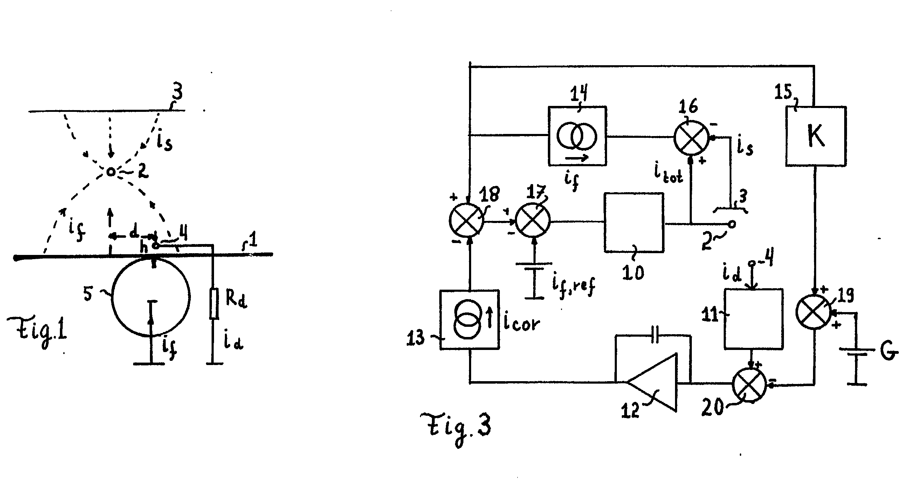

In Fig. 1, a photoconductor 1 is moved by a drive roller 5 past a corona electrode 2 at a distance therefrom. The rear screen or the like 3 is indicated diagrammatically at a distance from the corona electrode 2. A measuring wire 4 is clamped over the width of the photoconductor so as to be situated at the back of the corona spray cone. The way in which a photoconductor current $i_f$ and a screen current $i_s$ occur as a result of the negative potential - $V_0$ of the corona electrode is illustrated diagrammatically. The measuring wire 4 is earthed through a low-ohm resistor $R_d$. The measuring current $i_d$ of the order of a few µA's is determined by various factors. Firstly this current is determined by the field strength between the corona electrode and the measuring wire (zero potential) itself; with reasonable accuracy this part of the current is fixed part of the photoconductor current $i_f$, in dependence on the construction. A second part of the current is determined by the field strength as a result of the charge level or surface potential (ASV = apparent surface voltage) of the photoconductor 1 near the measuring wire 4. An increasing negative charge of the photoconductor will cause this part of the current flowing through the resistor $R_d$ to increase. The signal delivered across the measuring resistor $R_d$ is now approximately equal to:

$$i_d R_d = K(i_f) + F(ASV) + G$$

in which G, K and F are constants and K<1 and F<1.

By measuring the factor $K(i_f)$, and since the constant G is fixed, the rest of the signal $i_d R_d$ can be used to control the high-voltage source of the corona electrode 2 and hence for controlling the surface potential (ASV) of the photoconductor.

In Fig. 2 as an example the relationship between the photoconductor current $i_f$ and the wire current $i_d$ is given for different surface potentials ASV as a parameter in the case of a pin corona device. The relationship $i_d/i_f$ is linear except for the foot at the origin. This region ($<40$ µA) is outside the working range and is also unimportant. The above-mentioned constant G indicates the shift of a given line with respect to that of ASV = 0. Apart from the dependence of the wire current $i_d$ on the photoconductor current $i_f$ and the surface potential ASV, the positioning (see Fig. 1) of the measuring wire 4 plays a part. The value of the wire current increases with increasing h or decreasing d. For a sensitive detector it is desirable that $di_d/dASV$ should be large. This is obtained by making h and d small, e.g. h = about 1 mm. The $i_d$ variations as a result of ASV variations with respect to the absolute value $i_d$, i.e. $(di_d/dASV)|i_d|$, must be large. This can be achieved by making h small.

Fig. 3 diagrammatically represents an application of the invention in which application the invention is used to control the surface potential. A high-voltage source 10 feeds the corona electrode 2. The current $i_d$ taken from the measuring wire 4 is converted to voltage in a measuring circuit 11 and fed to the differential element 20. The photoconductor current $i_f$ in the measuring circuit 14 is measured in a first feedback loop and converted to a voltage which is compared in the differential element 17 with a voltage corresponding to the required current value $i_{f,ref}$. The result of this differential measurement is fed to the high voltage source 10 so that a stabilized photoconductor current is obtained.

The voltage in the voltage divider 15 corresponding to the $i_f$ current value is divided by the factor K in a second feedback loop and is increased by the constant value G in the differential element 19. The result is compared, in the differential element 20, with the voltage of the measuring circuit 11 corresponding to the wire current $i_d$. The output signal of the differential element 20 is the corrected measure E of the surface potential. The corrected measure E is used as an input signal to an integrating controller 12. The surface potential is so controlled by means of the second integrating feedback loop that the measure E of the surface potential becomes equal to zero.

The time constant of the integration amplifier 12 is, for example, one second, so that deviations of, for example, 100 V can be corrected within 1 second, within charging of the image area on the photoconductor. An ASV deviation, however, is measured as an average over the total photoconductor width so that an ASV variation as high as this over the width generally does not occur.

The control system operates as follows:

Immediately after switching on, the high-voltage supply is controlled for about 50 msec in a preset current mod. This means that the supply acts as a fixed current source, the current setting of which is so selected that the photoconductor charge accompanying it cannot become exceptionally high. This obviates any damage to the photoconductor on switching on. This pre-charging interval of 50 msec corresponds to the said transit time between the corona device and the measuring wire; during that interval of time after switching on there is in fact no signal in the measuring wire. Control in this preset current mode is obtained by setting the gain of the integration amplifier 12 to a minimum, the output voltage being set to the preset value. After that interval, this feedback loop for the ASV control is closed by increasing the integration amplifier gain, e.g. to 180x.

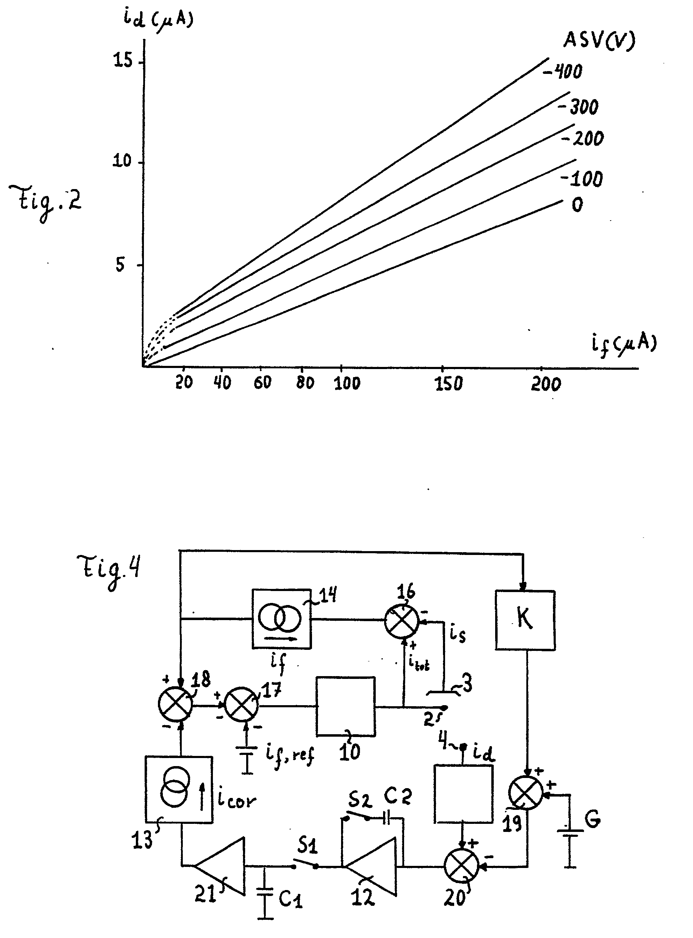

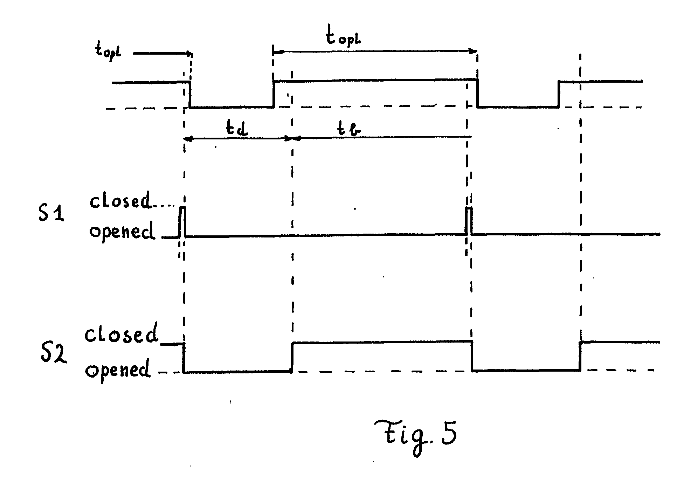

Fig. 4 diagrammatically represents a control system using the invention. The control system is basically the same as that of Fig. 3 except that the buffer amplifier 21 is included and a circuit $S_1$ and a capacitor $C_1$ to earth are included in the output circuit of the integration amplifier 12, while a switch $S_2$ is included in the feedback loop of the integration amplifier 12. The operaton of this control system will be explained by reference to Fig. 5.

During image charging in the interval $t_{opl}$ the switch $S_1$ is opened so that the high-voltage source 10 is controlled by a signal corrected by a correction signal of constant value from capacitor $C_1$. Switch $S_1$ is closed only briefly at the end of the image charging interval $t_{opl}$. The switch $S_2$ is closed during the image movement interval $t_b$ so that in that interval the integration amplifier 12 will determine the correction signal for the next charging. After this image movement interval $t_b$, the switch $S_1$, as stated briefly closes so that the capacitor $C_1$ can take over the correction signal from the integration capacitor $C_2$. This correction signal from capacitor $C_1$ is used during the pre-charging interval $t_d$ to correct the control for the high-voltage source.

The substantially open condition of the two switches $S_1$ and $S_2$ is necessary in order to avoid any leakage of the capacitor charges in a standby situation. In this example, each capacitor will hold its voltage approximately 8 hours or more. This also prevents the integration amplifier 12 from coming up against the feed voltage. In order to avoid any influencing of the correction signal by short-term charging disturbances, the time constant must be made large, i.e. >5 sec. As a result, after the high-voltage source has been switched on or after a possibly long standby situation, a pre-charging interval of several seconds has to be applied before a first charging can be made.

It is clear that in this second embodiment no correction takes place during charging by the control system. Control of the high-voltage supply is determined by the correction signal detected during the previous charging. The correction thus lags one charging behind. Also, no pre-charging path is required in a series of consecutive chargings. Against this, a pre-charging interval of about 5 seconds must be applied for a first charging or after a possibly long standby situation.

The operation of the control system according to the first embodiment depends on the properties of the photoconductor. In the case of a uniform charging, e.g. ±20V, in which the photoconductor uniformity variations are of low-frequency, i.e. there are no abrupt charge variations, the control system selected will operate without problems. The advantage is also that small charging differences within one image area can be corrected directly. When the charging differences are considerable, for example ± 50 V, and of high-frequency, e.g. several abrupt variations per image area, the influence on the control system is measurable and such influence may be undersirable.

This problem is obviated in the second embodiment, but a correction of the charging differences in one image area is then impossible.

As described hereinbefore, the invention is suitable primarily for use in control systems for controlling the surface potential of a photoconductor fed past a corona device for charging purposes. However, the invention is equally applicable to those cases in which measurement of the ASV is desirable for other purposes.

In the above-described embodiments of the invention, the measure $i_f$ is obtained by determining the difference between the current $i_{tot}$ emitted by the corona electrode and the screen current $i_s$. However, in practice it has been found that the ratio

$$\frac{i_f}{i_{tot}}$$

is approximately constant over a fairly wide area.

The measure $i_f$ can accordingly if required easily be determined from the value $i_{tot}$ in accordance with the relation $i_f = K2\ i_{tot}$. Measurement of the screen current $i_s$ is then superfluous. Although this determination of the current $i_f$ is less accurate than the determination of $i_f$ according to the equation $i_f = i_{tot} - i_s$, this method is quite satisfactory in practice if the accuracy of the determination of $i_f$ is not required to satisfy unduly strict requirements.

## Claims

1. A method of determining a measure E of the surface potential of a medium charged by means of a corona charging device, in which charge emitted by the corona electrode or electrodes (2) is deposited on the medium surface (1) and a measuring wire (4) is disposed near the charged suface (1) to collect a part of the emitted charge, and in which the measure E is derived from the value $i_d$ of the charge current collected by the measuring wire (4), characterised in that
- a measure $i_f$ of the portion of the emitted charge current that is conveyed to the medium (1) is determined, and
- the measure E is corrected by a correction C which correction is an invariant first order function of $i_f$.

2. A method according to claim 1, characterised in that the value $i_{tot}$ of the charge current emitted by the corona electrode or electrodes is determined and in that the measure $i_f$ is derived from $i_{tot}$ in accordance with a fixed relation.

3. A method according to claim 1, characterised in that the position of the measuring wire is so selected that the measuring wire (4) collects only charge moving towards this medium surface (1).

4. A device for performing the method according to claim 1, 2 or 3, which device comprises a measuring wire (4) disposed near the surface (1) to be charged, and a first measuring circuit (11) for determining the value $i_d$ of the current collected by the measuring wire (4), the measuring circuit (11) delivering a first signal which represents the value of the determined current, characterised in that the device comprises a second measuring circuit (14) for determining the value $i_f$, which delivers a second signal which represents the determined value $i_f$, and a computer circuit (15, 19, 20) to which the first signal and the second signal are fed, and which from the supplied signals generates in accordance with a fixed relation therebetween an output signal which represents the measure E.

## Patentansprüche

1. Methode zum Ermitteln eines Maßes E für das Oberflächenpotential eines mittels einer Korona-Aufladeeinrichtung aufgeladenen Mediums, bei der die von der Korona-Elektrode oder der Korona-Elektroden (2) emittierte Ladung auf der Oberfläche (1) des Mediums abgelagert wird und ein Meßdraht (4) in der Nähe der aufgeladenen Oberfläche (1) angeordnet wird, um einen Teil der emittierten Ladung zu sammeln, und bei der das Maß E aus dem Wert $i_d$ des von dem Meßdraht (4) gesammelten Ladungsstromes abgeleitet wird, dadurch gekennzeichnet, daß
- ein Maß $i_f$ für den Anteil des emittierten Ladungsstromes ermittelt wird, der auf das Medium (1) übertragen wird, und
- das Maß E durch eine Korrektur C korrigiert wird, wobei die Korrektur eine invariante Funktion ersten Grades von $i_f$ ist.

2. Methode nach Anspruch 1, dadurch gekennzeichnet, daß der Wert $i_{tot}$ des durch die Korona-Elektrode oder -Elektroden emittierten Ladungsstromes bestimmt wird und daß das Maß $i_f$ anhand einer festen Beziehung aus $i_{tot}$ abgeleitet wird.

3. Methode nach Anspruch 1, dadurch gekennzeichnet, daß die Position des Meßdrahtes so gewählt wird, daß der Meßdraht (4) nur Ladungen auffängt, die sich in Richtung auf diese Oberfläche (1) des Mediums bewegen.

4. Vorrichtung zur Durchführung der Methode nach Anspruch 1, 2 oder 3, mit einem in der Nähe der aufzuladenden Oberfläche (1) angeordneten Meßdraht (4) und einer ersten Meßschaltung (11) zur Bestimmung des Wertes $i_d$ des von dem Meßdraht (4) gesammelten Stromes, wobei die Meßschaltung (11) ein erstes Signal liefert, das den Wert des ermittelten Stromes repräsentiert, dadurch gekennzeichnet, daß die Vorrichtung eine zweite Meßschaltung (14) zur Bestimmung des Wertes $i_f$ aufweist, welche zweite Meßschaltung ein zweites Signal liefert, das den ermittelten Wert $i_f$ repräsentiert, sowie eine Rechenschaltung (15, 19, 20) aufweist, an der das erste Signal und das zweite Signal zugeführt werden, und welche aus den zugeführten Signalen anhand einer festen Beziehung zwischen diesen ein Ausgangssignal erzeugt, das das Maß E repräsentiert.

**Revendications**

1. Procédé de détermination d'une mesure E du potentiel de surface d'un support chargé par un dispositif de charge par effluves, dans lequel une charge émise par l'électrode ou les électrodes (2) de création d'effluves est déposée à la surface (1) du support et un fil de mesure (4) est placé à proximité de la surface chargée (1) afin qu'il collecte une partie de la charge émise, et dans lequel la mesure E est tirée de la valeur $i_d$ du courant de charge collecté par le fil de mesure (4), caractérisé en ce que:
   – une mesure $i_f$ de la partie du courant de charge émis qui est transportée vers le support (1) est déterminée, et
   – la mesure E est corrigée par un facteur de correction C qui est une fonction invariante du premier ordre de $i_f$.

2. Procédé selon la revendication 1, caractérisé en ce que la valeur $i_{tot}$ du courant de charge émis par l'électrode ou les électrodes de création d'effluves est déterminée, et en ce que la mesure $i_f$ est tirée de $i_{tot}$ en fonction d'une relation fixe.

3. Procédé selon la revendication 1, caractérisé en ce que la position du fil de mesure est choisie de manière que le fil de mesure (4) collecte uniquement la charge se déplaçant vers cette surface (1) du support.

4. Appareil destiné à la mise en œuvre du procédé selon la revendication 1, 2 ou 3, l'appareil comprenant un fil de mesure (4) placé près de la surface (1) qui doit être chargée, et un premier circuit de mesure (11) destiné à déterminer la valeur $i_d$ du courant collecté par le fil de mesure (4), le circuit de mesure (11) délivrant un premier signal qui représente la valeur du courant déterminé, caractérisé en ce que l'appareil comporte un second circuit de mesure (14) destiné à déterminer la valeur $i_f$, qui transmet un second signal qui représente la valeur déterminée $i_f$, et un circuit d'ordinateur (15, 19, 20) auquel le premier et le second signal sont transmis et qui, à partir des signaux transmis, crée un signal de sortie qui représente la mesure E à l'aide d'une relation fixe entre ces signaux.

EP 0 207 554 B1

Fig.1

Fig.3

Fig.2

Fig.4

Fig. 5

EP 0 207 554 B1